(19)

Europäisches Patentamt
European Patent Office
Office européen des brevets

(11) **EP 2 554 719 A1**

(12) **EUROPEAN PATENT APPLICATION**
published in accordance with Art. 153(4) EPC

(43) Date of publication:
06.02.2013 Bulletin 2013/06

(21) Application number: 11762562.4

(22) Date of filing: 15.03.2011

(51) Int Cl.:
*C30B 29/38* (2006.01)     *C30B 29/06* (2006.01)
*H01L 21/205* (2006.01)    *H01L 21/338* (2006.01)
*H01L 29/778* (2006.01)    *H01L 29/812* (2006.01)

(86) International application number:
**PCT/JP2011/055990**

(87) International publication number:
**WO 2011/122322 (06.10.2011 Gazette 2011/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: 31.03.2010 JP 2010080058

(71) Applicant: **NGK Insulators, Ltd.
Nagoya-shi, Aichi 467-8530 (JP)**

(72) Inventors:
• **MIYOSHI, Makoto
  Inazawa-shi
  Aichi 492-8137 (JP)**
• **SUMIYA, Shigeaki
  Nagoya-shi
  Aichi 467-8530 (JP)**

• **ICHIMURA, Mikiya
  Nagoya-shi
  Aichi 467-8530 (JP)**
• **MAEHARA, Sota
  Nagoya-shi
  Aichi 467-8530 (JP)**
• **TANAKA, Mitsuhiro
  Tsukuba-shi
  Ibaraki 305-0821 (JP)**

(74) Representative: **Naylor, Matthew John et al
Mewburn Ellis LLP
33 Gutter Lane
London
EC2V 8AS (GB)**

(54) **EPITAXIAL SUBSTRATE AND METHOD FOR MANUFACTURING EPITAXIAL SUBSTRATE**

(57)     Provided is a crack-free epitaxial substrate. An epitaxial substrate is provided in which a group of group-III nitride layers are formed on a base substrate made of (111)-oriented single crystal silicon such that a (0001) crystal plane of the group of group-III nitride layers is substantially in parallel with a substrate surface of the base substrate. The epitaxial substrate includes: a buffer layer formed of a first lamination unit and a second lamination unit being alternately laminated such that each of an uppermost portion and a lowermost portion of the buffer layer is formed of the first lamination unit; and a crystal layer formed on the buffer layer. The first lamination unit is formed of a first composition layer and a second composition layer having different compositions being alternately laminated so as to increase the thickness of the second composition layer in a portion more distant from the base substrate side, to thereby cause a compressive strain to exist in the first lamination unit such that the compressive strain increases in a portion more distant from the base substrate. The second lamination unit is formed as an intermediate layer that is substantially strain-free and formed with a thickness of 15 nm or more and 150 nm or less.

F I G. 1

EP 2 554 719 A1

**Description**

TECHNICAL FIELD

The present invention relates to an epitaxial substrate for use in a semiconductor device, and particularly to an epitaxial substrate made of a group-III nitride.

BACKGROUND ART

A nitride semiconductor is attracting attention as a semiconductor material for a light-emitting device such as a LED or a LD and for a high-frequency/high-power electronic device such as a HEMT, because the nitride semiconductor has a wide band gap of direct transition type and the breakdown electric field and the saturation electron velocity thereof are high. For example, a HEMT (high electron mobility transistor) device in which a barrier layer made of AlGaN and a channel layer made of GaN are laminated takes advantage of the feature that causes a high-concentration two-dimensional electron gas (2DEG) to occur in a lamination interface (hetero interface) due to the large polarization effect (a spontaneous polarization effect and a piezo polarization effect) specific to a nitride material (for example, see Non-Patent Document 1).

In some cases, a single crystal (a different kind single crystal) having a composition different from that of a group-III nitride, such as SiC, is used as a base substrate for use in a HEMT-device epitaxial substrate. In this case, a buffer layer such as a strained-superlattice layer or a low-temperature growth buffer layer is generally formed as an initially-grown layer on the base substrate. Accordingly, a configuration in which a barrier layer, a channel layer, and a buffer layer are epitaxially formed on a base substrate is the most basic configuration of the HEMT-device substrate including a base substrate made of a different kind single crystal. Additionally, a spacer layer having a thickness of about 1 nm may be sometimes provided between the barrier layer and the channel layer, for the purpose of facilitating a spatial confinement of the two-dimensional electron gas. The spacer layer is made of, for example, AlN. Moreover, a cap layer made of, for example, an n-type GaN layer or a superlattice layer may be sometimes formed on the barrier layer, for the purpose of controlling the energy level at the most superficial surface of the HEMT-device substrate and improving contact characteristics of contact with an electrode.

The HEMT device and the HEMT-device substrate involve various problems including problems concerning improvement of the performance such as increasing the power density and efficiency, problems concerning improvement of the functionality such as a normally-off operation, fundamental problems concerning a high reliability and cost reduction, and the like. Active efforts are made on each of the problems.

On the other hand, in the preparation of the above-mentioned nitride device, research and development have been made about the use of single crystal silicon for a base substrate for the purpose of reduction of the cost of an epitaxial substrate, furthermore, integration with a silicon-based circuit device, and the like (for example, see Patent Documents 1 to 3, and Non-Patent Document 2). In a case where a conductive material such as silicon is selected for the base substrate of the HEMT-device epitaxial substrate, a field plate effect is applied from a back surface of the base substrate, and therefore a HEMT device can be designed for a high breakdown voltage and high-speed switching.

It is already known that, in order that the HEMT-device epitaxial substrate can be structured with a high breakdown voltage, it is effective to increase the total film thickness of the channel layer and the barrier layer and to improve the electrical breakdown strength of both of the layers (for example, see Non-Patent Document 2).

A method for manufacturing a semiconductor device is also known in which an interposed layer made of AlN is formed on a Si base substrate, then a first semiconductor layer made of GaN and a second semiconductor layer made of AlN are alternately formed so as to cause convex warping as a whole, and then these layers are made contract at a subsequent temperature drop, to result in cancellation of the warping of the entire substrate (for example, see Patent Document 4).

However, it is known that forming a nitride film of good quality on a silicon substrate is very difficult as compared with a case of using a sapphire substrate or a SiC substrate, for the following reasons.

Firstly, the values of the lattice constants of silicon and nitride materials are greatly different from each other. This causes a misfit dislocation at an interface between the silicon substrate and a growth film, and facilitates a three-dimensional growth mode at a timing from the nucleus formation to the growth. In other words, this is a factor that hinders the formation of a good nitride epitaxial film having a low dislocation density and a flat surface.

Additionally, the nitride material has a higher thermal expansion coefficient value than that of silicon. Therefore, in the step of lowering the temperature to the vicinity of the room temperature after a nitride film is epitaxially grown on the silicon substrate at a high temperature, a tensile stress acts in the nitride film. As a result, it is likely that cracking occurs in a film surface and large warping occurs in the substrate.

Moreover, it is also known that trimethylgallium (TMG) that is a material gas of the nitride material for a vapor-phase growth is likely to form a liquid-phase compound with silicon, which is a factor that hinders the epitaxial growth.

In a case where the conventional techniques disclosed in the Patent Documents 1 to 3 and in the Non-Patent Document 1 are adopted, it is possible to cause an epitaxial growth of a GaN film on the silicon substrate. However, the resulting GaN film never has a better crystal quality as compared with a case of using SiC or sapphire for the base substrate. Therefore, preparing an electronic device such as a HEMT using the conventional techniques involves problems of a low electron mobility, a leakage current during the off-time, and a low breakdown voltage.

Furthermore, in the method disclosed in the Patent Document 4, large convex warping is intentionally caused in the course of the device preparation. This may cause cracking in the course of the device preparation, depending on conditions under which the layers are formed.

PRIOR-ART DOCUMENTS

PATENT DOCUMENTS

Patent Document 1: Japanese Patent Application Laid-Open No. 10-163528 (1998)
Patent Document 2: Japanese Patent Application Laid-Open No. 2004-349387
Patent Document 3: Japanese Patent Application Laid-Open No. 2005-350321
Patent Document 4: Japanese Patent Application Laid-Open No. 2009-289956

NON-PATENT DOCUMENTS

Non-Patent Document 1: "Highly Reliable 250W GaN High Electron Mobility Transistor Power Amplifier", Toshihide Kikkawa, Jpn. J. Appl. Phys. 44, (2005), 4896.

Non-Patent Document 2: "High power AlGaN/GaN HFET with a high breakdown voltage of over 1.8kV on 4 inch Si substrates and the suppression of current collapse", Nariaki Ikeda, Syuusuke Kaya, Jiang Li, Yoshihiro Sato, Sadahiro Kato, Seikoh Yoshida, Proceedings of the 20th International Symposium on Power Semiconductor Devices & IC's May 18-22, 2008 Orlando, FL", pp.287-290

SUMMARY OF THE INVENTION

The present invention has been made in view of the problems described above, and an object of the present invention is to provide a crack-free epitaxial substrate in which a silicon substrate is used as a base substrate.

To solve the problems described above, a first aspect of the present invention is an epitaxial substrate in which a group of group-III nitride layers are formed on a base substrate made of (III)-oriented single crystal silicon such that a (0001) crystal plane of the group of group-III nitride layers is substantially in parallel with a substrate surface of the base substrate. The epitaxial substrate includes: a buffer layer formed of a first lamination unit and a second lamination unit being alternately laminated such that each of an uppermost portion and a lowermost portion of the buffer layer is formed of the first lamination unit; and a crystal layer formed on the buffer layer. The first lamination unit is formed of a first composition layer and a second composition layer having different compositions being alternately laminated so as to satisfy the expressions of:

$$t(1) \le t(2) \le \ldots \le t(n-1) \le t(n);$$

and

$$t(1) < t(n),$$

where n represents the number of laminations of each of the first composition layer and the second composition layer (n is a natural number equal to or greater than two), and t(i) represents the thickness of i-th one of the second composition layers as counted from the base substrate side, to thereby cause a compressive strain to exist in the first lamination unit such that the compressive strain increases in a portion more distant from the base substrate. The second lamination unit is an intermediate layer that is substantially strain-free and formed with a thickness of 15 nm or more and 150 nm or less.

In a second aspect of the present invention, in the epitaxial substrate according to the first aspect, a second group-III nitride of the second composition layer has an in-plane lattice constant, under a strain-free state, greater than that of a first group-III nitride of the first composition layer; and each of the second composition layers is formed so as to be in a coherent state relative to the first composition layer.

In a third aspect of the present invention, in the epitaxial substrate according to the second aspect, the intermediate layer is made of a third group-III nitride whose in-plane lattice constant under a strain-free state is smaller than that of the second group-III nitride.

A fourth aspect of the present invention is an epitaxial substrate in which a group of group-III nitride layers are formed on a base substrate made of (111)-oriented single crystal silicon such that a (0001) crystal plane of the group of group-III nitride layers is substantially in parallel with a substrate surface of the base substrate. The epitaxial substrate includes: a buffer layer formed of a first lamination unit and a second lamination unit being alternately laminated such that each of an uppermost portion and a lowermost portion of the buffer layer is formed of the first lamination unit; and a crystal layer made of a group-III nitride and formed on the buffer layer. The first lamination unit is formed of a first composition layer made of a first group-III nitride and a second composition layer made of a second group-III nitride being alternately laminated so as to satisfy the expressions of:

$$t(1) \le t(2) \le \ldots \le t(n-1) \le t(n);$$

and

$$t(1) < t(n),$$

where n represents the number of laminations of each of the first composition layer and the second composition layer (n is a natural number equal to or greater than two), and t(i) represents the thickness of i-th one of the second composition layers as counted from the base substrate side. The second group-III nitride has an in-plane lattice constant, under a strain-free state, greater than that of the first group-III nitride. Each of the second composition layers is formed so as to be in a coherent state relative to the first composition layer. The second lamination unit is an intermediate layer made of a third group-III nitride formed with a thickness of 15 nm or more and 150 nm or less, the third group-III nitride having an in-plane lattice constant, under a strain-free state, smaller than that of the second group-III nitride.

In a fifth aspect of the present invention, in the epitaxial substrate according to any one of the first to fourth aspects, the first composition layer is made of AlN, and the second composition layer is made of a group-III nitride having a composition of $Al_xGa_{1-x}N$ $(0 \le x \le 0.25)$.

In a sixth aspect of the present invention, in the epitaxial substrate according to the fifth aspect, the second composition layer is made of a group-III nitride having a composition of $Al_xGa_{1-x}N$ $(0.1 \le x \le 0.25)$.

In a seventh aspect of the present invention, the epitaxial substrate according to any one of the first to sixth aspects further includes: a first base layer made of AlN and formed on the base substrate; and a second base layer made of $Al_pGa_{1-p}N$ $(0 \le p < 1)$ and formed on the first base layer. The first base layer is a layer with many crystal defects configured of at least one kind from a columnar or granular crystal or domain. An interface between the first base layer and the second base layer defines a three-dimensional concavo-convex surface. The buffer layer is formed immediately on the second base layer.

An eighth aspect of the present invention is a method for manufacturing an epitaxial substrate for use in a semiconductor device, the epitaxial substrate having a group of group-III nitride layers formed on a base substrate made of (111)-oriented single crystal silicon such that a (0001) crystal plane of the group of group-III nitride layers is substantially in parallel with a substrate surface of the base substrate. The method includes: a buffer layer formation step for forming a buffer layer by alternately laminating a first lamination unit and a second lamination unit such that each of an uppermost portion and a lowermost portion of the buffer layer is formed of the first lamination unit; and a crystal layer formation step for forming a crystal layer above the buffer layer, the crystal layer being made of a group-III nitride. The buffer layer formation step includes: a first lamination unit formation step for forming the first lamination unit by alternately laminating a first composition layer made of a first group-III nitride and a second composition layer made of a second group-III nitride; and said second lamination unit formation step for forming an intermediate layer on the first lamination unit. In the first lamination unit formation step, the first lamination unit is formed in such a manner that: the expressions of:

$$t(1) \le t(2) \le \ldots \le t(n-1) \le t(n);$$

and

$$t(1) < t(n),$$

are satisfied, where n represents the number of laminations of each of the first composition layer and the second composition layer (n is a natural number equal to or greater than two), and t(i) represents the thickness of i-th one of the second composition layers as counted from the base substrate side; the second group-III nitride has an in-plane lattice constant, under a strain-free state, greater than that of the first group-III nitride; and each of the second composition layers is in a coherent state relative to the first composition layer. In the second lamination unit formation step, the intermediate layer is formed with a thickness of 15 nm or more and 150 nm or less by using a third group-III nitride, the third group-III nitride having an in-plane lattice constant, under a strain-free state, smaller than that of the second group-III nitride.

In a ninth aspect of the present invention, in the method for manufacturing the epitaxial substrate according to the eighth aspect, the first composition layer is made of AlN, and the second composition layer is made of a group-III nitride having a composition of $Al_xGa_{1-x}N$ ($0 \leq x \leq 0.25$).

In a tenth aspect of the present invention, in the method for manufacturing the epitaxial substrate according to the eighth or ninth aspect, the second composition layer is made of a group-III nitride having a composition of $Al_xGa_{1-x}N$ ($0.1 \leq x \leq 0.25$).

In an eleventh aspect of the present invention, the method for manufacturing the epitaxial substrate according to any one of the eighth to tenth aspects further includes: a first base layer formation step for forming a first base layer on the base substrate, the first base layer being made of AlN; and a second base layer formation step for forming a second base layer on the first base layer, the second base layer being made of $Al_pGa_{1-p}N$ ($0 \leq p < 1$). In the first base layer formation step, the first base layer is formed as a layer with many crystal defects configured of at least one kind from a columnar or granular crystal or domain, such that a surface thereof is a three-dimensional concavo-convex surface. In the buffer layer formation step, the buffer layer is formed immediately on the second base layer.

In the first to eleventh aspects of the present invention, the compressive strain exists in the buffer layer. Accordingly, a tensile stress caused by a difference in a thermal expansion coefficient between silicon and a group-III nitride is cancelled by the compressive strain. Therefore, a crack-free epitaxial substrate having a small amount of warping and an excellent crystal quality can be obtained even when a silicon substrate is used as the base substrate.

Particularly, in the sixth and tenth aspects, a crack-free epitaxial substrate having a small amount of warping and excellent breakdown voltage properties is achieved.

Particularly, in the seventh and eleventh aspects, the buffer layer is provided on the base layer having a low dislocation and an excellent surface flatness. Accordingly, the buffer layer, the crystal layer, and the like, have good crystal quality. On the other hand, an accumulation of strain energy in the second base layer is suppressed. Therefore, the effect of canceling the tensile stress exerted by the compressive strain existing in the buffer layer is not hindered by any accumulation of strain energy in the base layer.

BRIEF DESCRIPTION OF THE DRAWINGS

[FIG. 1] A schematic cross-sectional view showing an outline configuration of an epitaxial substrate 10 according to an embodiment of the present invention.

[FIG. 2] A model diagram showing a crystal lattice at a time when a second composition layer 32 is formed on a first composition layer 31 in a composition modulation layer 3.

EMBODIMENT FOR CARRYING OUT THE INVENTION

<Outline Configuration of Epitaxial Substrate>

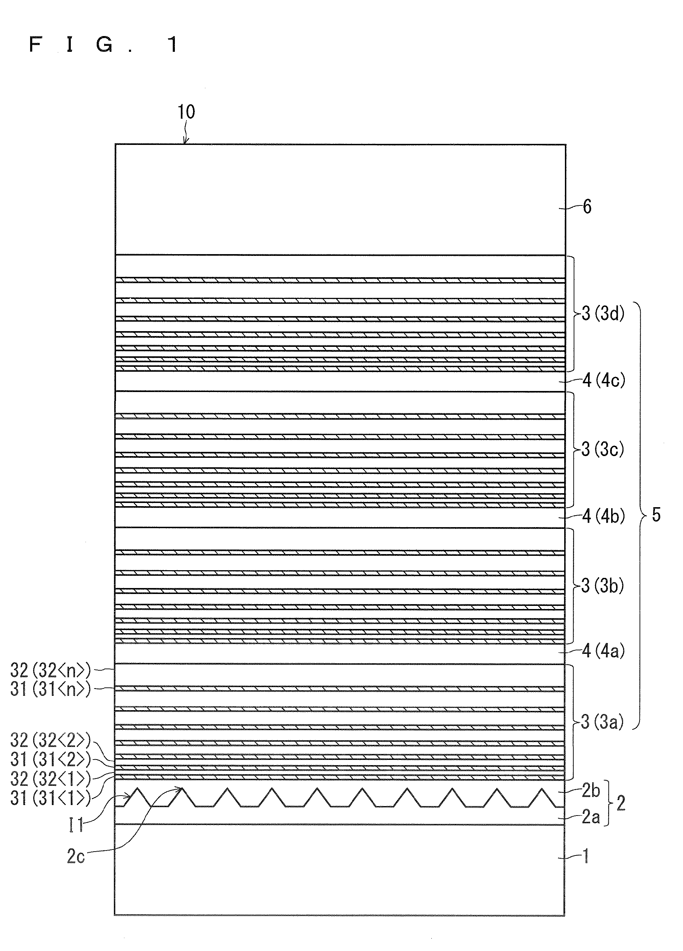

FIG. 1 is a schematic cross-sectional view showing an outline configuration of an epitaxial substrate 10 according to an embodiment of the present invention. The epitaxial substrate 10 mainly includes a base substrate 1, a base layer 2, a buffer layer 5, and a function layer 6. The buffer layer 5 includes a plurality of composition modulation layers 3 and a plurality of intermediate layers 4. In the following, the layers formed on the base substrate 1 will be sometimes collectively referred to as an epitaxial film. Here, for convenience of the description, the proportion of existence of Al in the group-III elements will be sometimes referred to as Al mole fraction.

The base substrate 1 is a wafer of (111) plane single crystal silicon having the p-type conductivity. The thickness of the base substrate 1 is not particularly limited, but for convenience of handling, it is preferable to use the base substrate 1 having a thickness of several hundred $\mu$m to several mm.

Each of the base layer 2, the composition modulation layer 3, the intermediate layer 4, and the function layer 6 is a layer formed of a wurtzite-type group-III nitride by using an epitaxial growth method such that a its (0001) crystal plane can be substantially in parallel with a substrate surface of the base substrate 1. In a preferred example, these layers are formed by a metalorganic chemical vapor deposition method (MOCVD method).

The base layer 2 is a layer provided for the purpose of enabling each of the above-mentioned layers to be formed thereon with a good crystal quality. To be specific, the base layer 2 is formed in such a manner that its dislocation density is suitably reduced and it has a good crystal quality at least near its surface (near an interface with the composition modulation layer 3). As a result, a good crystal quality is obtained in the composition modulation layer 3, and additionally in the layers formed thereon.

In this embodiment, to satisfy the purpose, the base layer 2 is composed of a first base layer 2a and a second base layer 2b, as described below.

The first base layer 2a is a layer made of AlN. The first base layer 2a is a layer configured of a large number of small columnar crystals or the like (at least one kind from columnar crystals, granular crystals, columnar domains, and granular domains) that have been grown in a direction (film formation direction) substantially perpendicular to the substrate surface of the base substrate 1. In other words, the first base layer 2a is a layer with many defects having inferior crystal properties, in which, although uniaxial orientation is achieved along a lamination direction of the epitaxial substrate 10, many crystal grain boundaries or dislocations exist along the lamination direction. In this embodiment, for convenience of the description, the crystal grain boundary is sometimes used as the term inclusive of domain grain boundaries and dislocations, too. In the first base layer 2a, the interval of the crystal grain boundaries is at most about several tens nm.

The first base layer 2a having this configuration is formed such that the half width of a (0002) X-ray rocking curve can be 0.5 degrees or more and 1.1 degrees or less and such that the half width of a (10-10) X-ray rocking curve can be 0.8 degrees or more and 1.1 degrees or less. The half width of the (0002) X-ray rocking curve serves as an index of the magnitude of mosaicity of a c-axis tilt component or the frequency of screw dislocations. The half width of the (10-10) X-ray rocking curve serves as an index of the magnitude of mosaicity of a crystal rotation component whose rotation axis is c-axis or the frequency of edge dislocations.

On the other hand, the second base layer 2b is a layer formed on the first base layer 2a and made of a group-III nitride having a composition of $Al_pGa_{1-p}N$ ($0 \leq <1$).

An interface I1 (a surface of the first base layer 2a) between the first base layer 2a and the second base layer 2b is a three-dimensional concavo-convex surface that reflects the outer shapes of the columnar crystals and the like included in the first base layer 2a. The fact that the interface I1 has such a shape is clearly confirmed in, for example, a HAADF (high-angle annular dark-field) image of the epitaxial substrate 10. The HAADF image is obtained by a scanning transmission electron microscope (STEM), and is a mapping image of the integrated intensity of electron that is inelastically scattered at a high angle. In the HAADF image, the image intensity is proportional to the square of an atomic number, and a portion where an atom having a greater atomic number exists is observed more brightly (more white). Therefore, the second base layer 2b containing Ga is observed relatively bright, and the first base layer 2a not containing Ga is observed relatively dark. Thereby, the fact that the interface I1 therebetween is configured as a three-dimensional concavo-convex surface is easily recognized.

In the schematic cross-section of FIG. 1, convex portions 2c of the first base layer 2a are located at substantially regular intervals. This is merely for convenience of illustration. Actually, the convex portions 2c are not necessarily located at regular intervals. Preferably, the first base layer 2a is formed such that the density of the convex portions 2c can be $5 \times 10^9$/cm$^2$ or more and $5 \times 10^{10}$/cm$^2$ or less and the average interval of the convex portions 2c can be 45 nm or more and 140 nm or less. When these ranges are satisfied, the function layer 6 having, particularly, an excellent crystal quality can be formed. In this embodiment, the convex portion 2c of the first base layer 2a always denotes a position substantially at the apex of an upward convex portion of the surface (interface I1). From the results of experiments and observations made by the inventors of the present invention, it has been confirmed that a side wall of the convex portion 2c is formed by a (10-11) plane or (10-12) plane of AlN.

In order that the convex portions 2c that satisfy the above-mentioned density and average interval can be formed on the surface of the first base layer 2a, it is preferable to form the first base layer 2a with an average film thickness of 40 nm or more and 200 nm or less. In a case where the average film thickness is less than 40 nm, it is difficult to achieve a state where the substrate surface is thoroughly covered with AlN while forming the convex portions 2c as described above. On the other hand, when the average film thickness exceeds 200 nm, flattening of an AlN surface starts to progress, to make it difficult to form the convex portions 2c described above.

The formation of the first base layer 2a is performed under predetermined epitaxial growth conditions. Here, forming the first base layer 2a with AlN is preferable in terms of not containing Ga which forms a liquid-phase compound with silicon and in terms of easily configuring the interface I1 as a three-dimensional concavo-convex surface because a horizontal growth is relatively unlikely to progress.

In the epitaxial substrate 10, the first base layer 2a that is a layer with many defects in which the crystal grain boundaries exist is interposed between the base substrate 1 and the second base layer 2b in the above-described manner. This relieves a lattice misfit between the base substrate 1 and the second base layer 2b, and thus an accumulation of strain energy caused by this lattice misfit is suppressed. The above-described ranges of the half widths of the (0002) and (10-10) X-ray rocking curves with respect to the first base layer 2a are set as ranges that can suitably suppress the accumulation of strain energy due to the crystal grain boundaries.

However, the interposition of the first base layer 2a causes an enormous number of dislocations originating from the crystal grain boundaries such as the columnar crystals of the first base layer 2a to propagate in the second base layer 2b. In this embodiment, as described above, the interface I1 between the first base layer 2a and the second base layer 2b is configured as a three-dimensional concavo-convex surface, and thereby such dislocations are effectively reduced.

Since the interface I1 between the first base layer 2a and the second base layer 2b is configured as a three-dimensional concavo-convex surface, most of the dislocations caused in the first base layer 2a are bent at the interface I1 during the propagation (penetration) from the first base layer 2a to the second base layer 2b, and coalesce and disappear within the second base layer 2b. As a result, only a small part of the dislocations originating from the first base layer 2a penetrates through the second base layer 2b.

Preferably, although the second base layer 2b is formed along the shape of the surface of the first base layer 2a (the shape of the interface I1) in an initial stage of the growth, the surface thereof is gradually flattened along with the progress of the growth, and finally obtains a surface roughness of 10 nm or less. In this embodiment, the surface roughness is expressed as an average roughness ra in a region of 5 μm × 5 μm which has been measured by an AFM (atomic force microscope). Here, in terms of obtaining a good surface flatness of the second base layer 2b, it is preferable that the second base layer 2b is formed of a group-III nitride having a composition that contains at least Ga, which allows a horizontal growth to progress relatively easily.

It is preferable that the second base layer 2b has an average thickness of 40 nm or more. This is because, when the average thickness is less than 40 nm, such problems arise that concaves and convexes caused by the first base layer 2a cannot sufficiently be flattened, and that the disappearance of dislocations having propagated to the second base layer 2b and coalesced with each other does not sufficiently occur. In a case where the average thickness is 40 nm or more, the reduction of the dislocation density and the flattening of the surface are effectively achieved. Therefore, in a technical sense, no particular limitation is put on an upper limit of the thickness of the second base layer 2b, but from the viewpoint of the productivity, it is preferable that the thickness is about several μm or less.

As described above, the surface of the second base layer 2b has a low dislocation and an excellent flatness, and therefore the layers formed thereon have a good crystal quality.

The buffer layer 5 has a configuration in which the intermediate layer 4 is interposed between ones of the plurality of composition modulation layers 3. In other words, the intermediate layer 4 is provided as a boundary layer between the composition modulation layers 3. Alternatively, in still other words, the buffer layer 5 has a configuration in which the uppermost and lowermost portions thereof are the composition modulation layers 3, and the composition modulation layer 3 serving as a first lamination unit and the intermediate layer 4 serving as a second lamination unit are alternately and repeatedly laminated. Although FIG. 1 illustrates a case where there are four composition modulation layers 3 (3a, 3b, 3c, 3d) and three intermediate layers 4 (4a, 4b, 4c), the numbers of the composition modulation layers 3 and the intermediate layers 4 are not limited thereto.

The composition modulation layer 3 is a part formed by a first composition layer 31 and a second composition layer 32, which are made of group-III nitrides having different compositions, being alternately and repeatedly laminated. In this embodiment, the i-th first composition layer 31 as counted from the base substrate 1 side is expressed as "31<i>", and the i-th second composition layer 32 as counted from the base substrate 1 side is expressed as "32<i>".

Each of the first composition layers 31 is formed with substantially the same thickness of about 3 to 20 nm, and typically 5 to 10 nm. On the other hand, the second composition layers 32 are formed so as to satisfy the following expressions 1 and 2, where n (n is a natural number equal to or greater than two) represents the number of the first composition layers 31 and the number of the second composition layers 32, and t(i) represents the thickness of the i-th second composition layer 32<i> from the base substrate 1 side.

$$t(1) \leq t(2) \leq \ldots \leq t(n-1) \leq t(n) \qquad \ldots \text{(Expression 1)}$$

$$t(1) < t(n) \qquad \ldots \text{(Expression 2)}$$

That is, the composition modulation layer 3 has a configuration in which the thickness of the second composition layer 32<n> is greater than that of the second composition layer 32<1> and, at least partially, the thickness of the second composition layer 32 gradually increases as the second composition layer 32 is more distant from the base substrate 1. This requirement is satisfied typically by forming the composition modulation layer 3 in such a manner that the second composition layer 32 more distant from the base substrate 1 has a greater thickness. Therefore, hereinafter, in this embodiment, it is assumed that the second composition layer 32 more distant from the base substrate 1 has a greater thickness, including a case where there exist a second composition layer 32<i-1> and a second composition layer 32<i> having the same thickness.

The thickness t(1) of the second composition layer 32<1> closest to the base substrate 1 is preferably about 10 to 25 nm and greater than the thickness of the first composition layer 31. On the other hand, the thickness t(n) of the second composition layer 32<n> most distant from the base substrate 1 is, though depending on the value of n, preferably about 150 to 350 nm. A requirement regarding the thickness t(i) of the second composition layer 32<i> will be described later.

The first composition layer 31 and the second composition layer 32 are formed to satisfy such a relationship that an in-plane lattice constant (lattice length) under a strain-free state (bulk state) is greater in the group-III nitride of the latter than in the group-III nitride of the former.

Additionally, in the composition modulation layer 3, the second composition layer 32 is formed so as to be coherent to the first composition layer 31.

Preferably, the first composition layer 31 is made of AlN, and the second composition layer 32 is made of a group-III nitride having a composition of $Al_xGa_{1-x}N$ ($0 \leq x \leq 0.25$). The Al mole fraction in the second composition layer 32 has a relationship with breakdown voltage properties of the epitaxial substrate 10 itself. Details thereof will be described later.

The intermediate layer 4 is a layer made of a group-III nitride whose in-plane lattice constant under a strain-free state is smaller than that of a group-III nitride of the second composition layer 32. The intermediate layer 4 is formed with a thickness of 15 nm or more and 150 nm or less. Preferably, the intermediate layer 4 is formed with a thickness of 15 nm or more and 90 nm or less. Preferably, the intermediate layer 4 is made of a group-III nitride having the same composition as that of the first composition layer 31. More preferably, the intermediate layer 4 is made of AlN.

The function layer 6 is at least one layer made of a group-III nitride and formed on the buffer layer 5. The function layer 6 is a layer that develops a predetermined function in a situation where predetermined semiconductor layers, electrodes, and the like, are additionally provided on the epitaxial substrate 10 to thereby form a semiconductor device. Accordingly, the function layer 6 is constituted of one or more layers having a composition and a thickness appropriate for this function. Although FIG. 1 illustrates a case where the function layer 6 is constituted of a single layer, the configuration of the function layer 6 is not limited thereto.

For example, a channel layer made of high-resistivity GaN and having a thickness of several $\mu$m and a barrier layer made of AlGaN, InAlN, or the like and having a thickness of several tens nm are laminated to serve as the function layer 6, and thereby the epitaxial substrate 10 for a HEMT device is obtained. That is, a HEMT device is obtained by forming a gate electrode, a source electrode, and a drain electrode on the barrier layer, though not shown. For forming these electrodes, a known technique such as a photolithography process is applicable. In such a case, a spacer layer made of AlN and having a thickness of about 1 nm may be provided between the channel layer and the barrier layer.

Alternatively, a concentric Schottky diode is achieved by forming one group-III nitride layer (for example, a GaN layer) as the function layer 6 and forming an anode and a cathode thereon, though not shown. For forming these electrodes, the known technique such as the photolithography process is also applicable.

<Method for Manufacturing Epitaxial Substrate>

Next, a method for manufacturing the epitaxial substrate 10 will be generally described while a case of using the MOCVD method is taken as an example.

Firstly, a (111) plane single crystal silicon wafer is prepared as the base substrate 1. A natural oxide film is removed by dilute hydrofluoric acid cleaning. Then, SPM cleaning is performed to create a state where an oxide film having a thickness of about several Å is formed on a wafer surface. This is set within a reactor of a MOCVD apparatus.

Then, each layer is formed under predetermined heating conditions and a predetermined gas atmosphere. Firstly, for the first base layer 2a made of AlN, a substrate temperature is maintained at a predetermined initial layer formation temperature of 800°C or higher and 1200°C or lower, and the pressure in the reactor is set to be about 0.1 to 30 kPa. In this state, a TMA (trimethylaluminum) bubbling gas that is an aluminum raw material and a $NH_3$ gas are introduced into the reactor with an appropriate molar flow ratio. A film formation speed is set to be 20 nm/min or higher, and a target film thickness is set to be 200 nm or less. Thereby, the formation of the first base layer 2a is achieved.

For the formation of the second base layer 2b, after the formation of the first base layer 2a, a substrate temperature is maintained at a predetermined second base layer formation temperature of 800°C or higher and 1200°C or lower, and the pressure in the reactor is set to be 0.1 to 100 kPa. In this state, a TMG (trimethylgallium) bubbling gas that is a gallium raw material, a TMA bubbling gas, and a $NH_3$ gas are introduced into the reactor with a predetermined flow ratio that is appropriate for a composition of the second base layer 2b to be prepared. Thus, $NH_3$ is reacted with TMA and TMG. Thereby, the formation of the second base layer 2b is achieved.

For the formation of the respective layers included in the buffer layer 5, that is, for the formation of the first composition layer 31 and the second composition layer 32 included in the composition modulation layer 3 and the intermediate layer 4, subsequent to the formation of the second base layer 2b, a substrate temperature is maintained at a predetermined formation temperature of 800°C or higher and 1200°C or lower that is appropriate for each of the layers, and the pressure in the reactor is maintained at a predetermined value of 0.1 to 100 kPa that is appropriate for each of the layers. In this state, a $NH_3$ gas and a group-III nitride material gas (TMA and TMG bubbling gases) are introduced into the reactor with a flow ratio that is appropriate for a composition to be achieved in each of the layers. Thereby, the formation of the respective layers is achieved. At this time, by changing the flow ratio at a timing appropriate for a set film thickness, the respective layers are formed in a continuous manner and with desired film thicknesses.

For the formation of the function layer 6, after the formation of the buffer layer 5, a substrate temperature is maintained at a predetermined function layer formation temperature of 800°C or higher and 1200°C or lower, and the pressure in the reactor is set to be 0.1 to 100 kPa. In this state, at least one of a TMI bubbling gas, a TMA bubbling gas, and a TMG bubbling gas, and a $NH_3$ gas are introduced into the reactor with a flow ratio that is appropriate for a composition of the function layer 6 to be prepared. Thus, $NH_3$ is reacted with at least one of TMI, TMA, and TMG. Thereby, the formation of the function layer 6 is achieved.

After the function layer 6 is formed, in the reactor, the temperature of the epitaxial substrate 10 is lowered to an ordinary temperature. Then, the epitaxial substrate 10 is taken out from the reactor and subjected to an appropriate subsequent process (such as patterning of an electrode layer).

<Functions and Effects of Buffer Layer>

Generally, as is the case for this embodiment as well, in a case of preparing an epitaxial substrate by causing a crystal layer made of a group-III nitride to epitaxially grow on a single crystal silicon wafer at a predetermined formation temperature, a tensile stress in an in-plane direction occurs in the crystal layer in the course of lowering the temperature to the ordinary temperature after the crystal growth, because the group-III nitride has a thermal expansion coefficient greater than that of silicon (for example, silicon: $3.4 \times 10^{-6}$/K, GaN: $5.5 \times 10^{-6}$/K). This tensile stress is a factor that causes occurrence of cracking and warping in the epitaxial substrate. In this embodiment, the buffer layer 5 is provided in the epitaxial substrate 10 for the purpose of reducing the tensile stress and suppressing occurrence of cracking and warping. More specifically, due to functions and effects exerted by each of the layers included in the buffer layer 5, occurrence of cracking and warping in the epitaxial substrate 10 are suppressed. In the following, a detailed description will be given.

(Composition Modulation Layer)

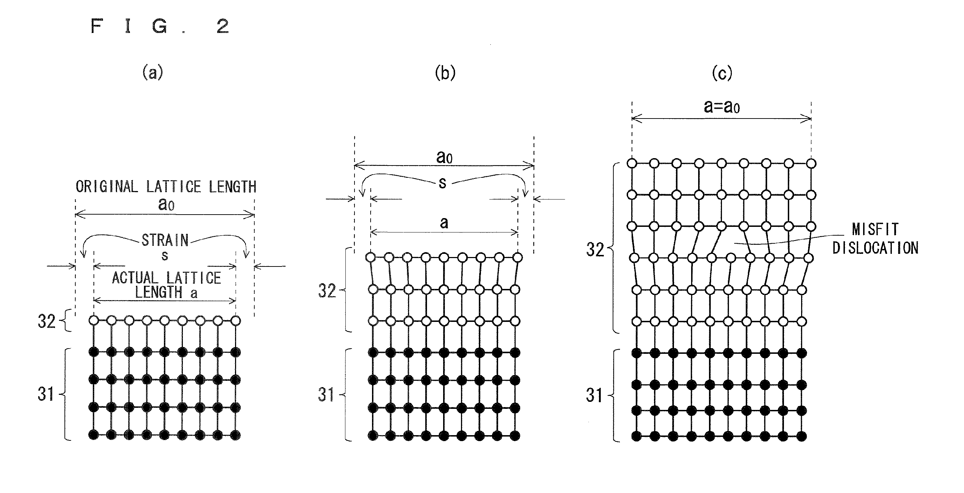

FIG. 2 is a model diagram showing a crystal lattice at a time when the second composition layer 32 is formed on the first composition layer 31 in the composition modulation layer 3. Here, the lattice length, in the in-plane direction, of the group-III nitride of the second composition layer 32 under the strain-free state is defined as $a_0$, and the actual lattice length thereof is defined as a. In this embodiment, as shown in FIG. 2(a)(b), a crystal growth progresses in the second composition layer 32 while keeping aligned with the crystal lattice of the first composition layer 31. This means that a compressive strain of $s=a_0-a$ occurs in the in-plane direction of the second composition layer 32 during the crystal growth. That is, the crystal growth of the second composition layer 32 progresses with strain energy held therein.

As the growth advances, energy instability increases. Therefore, a misfit dislocation is gradually introduced in the second composition layer 32, for releasing the strain energy. Then, upon reaching a certain critical state, the strain energy held in the second composition layer 32 is fully released. At this time, a state of $a=a_0$ is created as shown in FIG. 2(c).

However, if the formation of the second composition layer 32 is terminated in a state of $a_0>a$ as shown in FIG. 2(b) prior to reaching the state shown in FIG. 2(c), the second composition layer 32 remains holding the strain energy (remains containing the compressive strain). In this embodiment, such a crystal growth with the strain energy contained therein is referred to as a crystal growth in a coherent state. In other words, the second composition layer 32 is in the coherent state relative to the first composition layer 31 as long as the second composition layer 32 is formed with a thickness smaller than a critical film thickness at which the strain energy is fully released. Alternatively, in still other words, the second composition layer 32 is in the coherent state relative to the first composition layer 31 as long as the lattice length a of the uppermost surface of the second composition layer 32 (the surface that will be in contact with the first composition layer 31 located immediately above) satisfies $a_0>a$. Even if $a_0=a$ is created partially in the second composition layer 32, it can be said that the second composition layer 32 is in the coherent state relative to the first composition layer 31, as long as the second composition layer 32 contains the strain energy in the above-described manner.

The in-plane lattice constant of the group-III nitride of the first composition layer 31 is smaller than the in-plane lattice constant of the group-III nitride of the second composition layer 32. Therefore, even when the first composition layer 31 is formed on the second composition layer 32 with the strain energy held therein, the coherent state is maintained, not causing a release of the strain energy held in the second composition layer 32 located immediately below. Then, if the second composition layer 32 is again grown on this first composition layer 31 so as to make the coherent state, the same compressive strain as described above is also caused in this second composition layer 32, too.

Subsequently, in the same manner, the formation of the first composition layer 31 and the second composition layer 32 is alternately repeated while maintaining the growth in the coherent state. Thereby, the strain energy is held in each of the second composition layers 32. In such a case, moreover, as the second composition layer 32 is formed upper, the critical film thickness thereof increases, because the effect of the compressive strain is more greatly exerted from the lower side. Additionally, as the thickness increases, a larger compressive strain is contained in the second composition layer 32. In this embodiment, in view of these points, the composition modulation layer 3 is formed such that the (Expression 1) and (Expression 2) are satisfied, in other words, such that the second composition layer 32<i> more distant from the base substrate 1 has a greater thickness t(i) within a range not exceeding the critical film thickness. Accordingly, the composition modulation layer 3 can be considered as a strain-introduced layer configured such that a portion thereof located more distant from the base substrate 1 has a larger compressive strain contained therein.

This compressive strain acts in a direction exactly opposite to the direction of the tensile stress that is caused by a difference in the thermal expansion coefficient, and therefore functions to cancel the tensile stress at the time of temperature drop. In outline, the tensile stress is cancelled by a force that is proportional to the total sum of the magnitudes of the compressive strains contained in the n second composition layers 32.

The first composition layer 31 is interposed between the two second composition layers 32. The first composition layer 31 having too small a thickness is not preferable, because this reduces the compressive strain occurring in the second composition layer 32, and rather, the tensile stress is likely to exist in the first composition layer 31 itself. On the other hand, too large a thickness is not preferable, either, because the second composition layer 32 itself is likely to receive a force in a tensile direction. The above-mentioned requirement that the thickness is about 3 to 20 nm is preferable in terms of not causing such failures.

The above-mentioned requirement that the first composition layer 31 is made of AlN and the second composition layer 32 is made of a group-III nitride having a composition of $Al_xGa_{1-x}N$ ($0 \leq x \leq 0.25$) is preferable in terms of providing a sufficient amount of compressive strain in each individual second composition layer 32.

However, if the thickness t(1) of the second composition layer 32<1> is excessively greater relative to the thickness of the first composition layer 31, the second composition layer 32<1> may not be able to grow in a coherent state. Accordingly, it is preferable that the thickness of the second composition layer 32<1> is at most about the three times the thickness of the first composition layer 31. From the viewpoint of suitably achieving the growth in a coherent state, it is preferable that the thickness t(i) of the second composition layer 32<i> is at most about five to six times the thickness t(i-1) of the second composition layer 32<i-1>, though it depends on the total sum of the thicknesses of the first composition layers 31 and the second composition layers 32 that are formed below this second composition layer 32<i> in each of the composition modulation layers 3.

(Intermediate Layer)

As described above, the compressive strain exists in the entire composition modulation layer 3. Therefore, it is supposed that a large compressive strain sufficient for preventing occurrence of cracking should be obtained by laminating a plurality of the composition modulation layers 3. However, actually, even though one composition modulation layer 3 is formed immediately on another composition modulation layer 3, a sufficient compressive strain cannot be obtained in the upper composition modulation layer 3, for the following reasons. The group-III nitride of the second composition layer 32<n> that is the uppermost layer of the lower composition modulation layer 3 has an in-plane lattice constant, under the strain-free state, greater than that of the group-III nitride of the first composition layer 31<1> that is the lowermost layer of the upper composition modulation layer 3. Additionally, the first composition layer 31<1> is formed with a thickness of only about 3 to 20 nm. Accordingly, if the first composition layer 31<1> is formed directly on the second composition layer 32<n>, a tensile strain exists in the first composition layer 31<1>, and thus a sufficient compressive strain cannot be introduced in the subsequently-formed composition modulation layer 3.

Therefore, in this embodiment, the intermediate layer 4 is provided between the two composition modulation layers 3, thereby preventing occurrence of the above-described failures involved in the introduction of the tensile strain, and causing a sufficient compressive strain to exist in each individual composition modulation layer 3.

To be specific, on the second composition layer 32<n> that is the uppermost layer of the composition modulation layer 3, the intermediate layer 4 made of a group-III nitride whose in-plane lattice constant under the strain-free state is smaller than the group-III nitride of the aforesaid second composition layer 32 is formed. In the intermediate layer 4 provided in this manner, a misfit dislocation caused by a difference in the lattice constant from the second composition layer 32 exists in the vicinity of an interface with the second composition layer 32<n>, but a lattice relaxation occurs at least in the vicinity of the surface thereof, to achieve a substantially strain-free state in which no tensile stress acts. Here, being substantially strain-free means that at least a portion other than the vicinity of the interface with the second composition layer 32<n> located immediately below has substantially the same lattice constant as the lattice constant under the bulk state.

In the composition modulation layer 3 formed on such a substantially strain-free intermediate layer 4, no tensile stress acts on the first composition layer 31<1> that is the lowermost layer of this composition modulation layer 3. Therefore, this composition modulation layer 3 is also formed in such a manner that a compressive strain suitably exists therein, similarly to the composition modulation layer 3 located immediately below the intermediate layer 4.

Preferably, both the first composition layer 31 and the intermediate layer 4 are made of AIN. In this case, by continuously forming the intermediate layer 4 and the first composition layer 31<1>, both of them are configured as substantially one layer. This can more surely prevent a tensile stress from acting on the first composition layer 31<1>.

Here, it is necessary that the intermediate layer 4 is formed with a thickness of 15 nm or more and 150 nm or less. In a case where the thickness of the intermediate layer 4 is less than 15 nm, a tensile stress acts on the intermediate layer 4 similarly to a case where the first composition layer 31<1> is formed directly on the second composition layer 32<n>, and the composition modulation layer 3 is formed under an influence thereof. As a result, a compressive strain does not suitably exist in the composition modulation layer 3. It is not preferable. On the other hand, in a case where the thickness of the intermediate layer 4 is more than 150 nm, an influence of a difference in the thermal expansion coefficient between the intermediate layer 4 itself and silicon of the base substrate 1 is not negligible, and a tensile stress caused by the difference in the thermal expansion coefficient acts on the intermediate layer 4. It is not preferable. In either case, cracking occurs in the epitaxial substrate 10. Forming the intermediate layer 4 with a thickness of 15 nm or more and 150 nm or less enables the intermediate layer 4 to be in a substantially strain-free state, so that a state where no tensile stress acts on the first composition layer 31<1> located immediately above is created. As a result, the crack-free epitaxial substrate 10 is achieved.

In a case of providing more composition modulation layers 3, the intermediate layer 4 is interposed between one of the composition modulation layers 3 in the same manner as described above, to thereby achieve a state where a compressive strain suitably exists in all the composition modulation layers 3. As long as the condition that the composition modulation layers 3 have the same configuration, the compressive strain existing in the buffer layer 5 becomes large as the number of repetitions of lamination of the composition modulation layers 3 increases.

In the epitaxial substrate 10 including the buffer layer 5 configured in the above-described manner, due to the large compressive strain existing in the buffer layer 5, a state is achieved in which a tensile stress caused by a difference in the thermal expansion coefficient between silicon and the group-III nitride is suitably cancelled. Thereby, the epitaxial substrate 10 can be made crack-free. Additionally, due to the cancellation of the tensile stress, the amount of warping in the epitaxial substrate 10 is suppressed to 100 $\mu$m or less.

That is, in the epitaxial substrate 10 according to this embodiment, the buffer layer 5 is provided by alternately laminating the composition modulation layer 3 serving as the strain-introduced layer and the substantially strain-free intermediate layer 4. This causes a large compressive strain to exist in the buffer layer 5, to suitably reduce a tensile stress caused in the epitaxial substrate 10 due to the difference in the thermal expansion coefficient between silicon and the group-III nitride. As a result, in the epitaxial substrate 10, a crack-free state is achieved and warping is reduced.

Since the buffer layer 5 is formed on the second base layer 2b in which an accumulation of strain energy is suppressed as described above, the effect of canceling the tensile stress is not hindered by any strain energy accumulated in the second base layer 2b.

Moreover, repeatedly laminating the composition modulation layer 3 and the intermediate layer 4 increases the total film thickness of the epitaxial film itself. In general, in a case where a HEMT device is prepared using the epitaxial substrate 10, as the total film thickness thereof increases, the breakdown voltage of the HEMT device becomes higher. Thus, the configuration of the epitaxial substrate 10 according to this embodiment also contributes to increase of the breakdown voltage.

<Increase of Breakdown Voltage of Epitaxial Substrate>

In this embodiment, by varying configuration parameters of the buffer layer 5 (such as the composition and the thickness of each layer, the number of the first composition layers 31, the number of the second composition layers 32, and the number of repetitions of lamination of the composition modulation layers 3), various epitaxial substrates 10 having different specific configurations are obtained.

Particularly, by forming the second composition layer 32 with a group-III nitride having a composition of $Al_xGa_{1-x}N$ ($0.1 \leq x \leq 0.25$), the epitaxial substrate 10 that is crack-free and has a high breakdown voltage is achieved. In this embodiment, the breakdown voltage means a voltage value at which a leakage current of 1 mA/cm$^2$ occurs in a case where the voltage is applied to the epitaxial substrate 10 while being increased from 0V. For example, in a case where the buffer layer 5 is formed such that the total film thickness of the entire epitaxial film except the base substrate 1 is 4.0

μm or less while the total film thickness of the second composition layers 32 is 1700 nm or more, a high breakdown voltage of 600V or higher is achieved.

In such a case, if the thickness and the number of laminations of each layer are identical, there is a tendency that the breakdown voltage increases as the Al mole fraction (corresponding to *x* mentioned above) in the second composition layer 32 becomes higher within the above-mentioned composition range.

If the number of repetitions of lamination of the composition modulation layers 3, the total film thickness of the entire epitaxial film, and the total film thickness of the second composition layers 32 are appropriately set, the epitaxial substrate 10 having a higher breakdown voltage can be obtained. For example, an epitaxial substrate in which the total film thickness of the entire epitaxial film is 5 μm and the breakdown voltage is 1000V or higher, and an epitaxial substrate in which the total film thickness of the entire epitaxial film is 7 μm and the breakdown voltage is 1400V or higher, can be achieved.

As described above, in this embodiment, the buffer layer is provided between the base substrate and the function layer by alternately laminating the substantially strain-free intermediate layer and the composition modulation layer having a compressive strain held therein due to the first composition layer and the second composition layer being alternately laminated in such a manner that the thickness of the second composition layer increases in a upper portion. Accordingly, a crack-free epitaxial substrate having an excellent crystal quality can be obtained in which a silicon substrate, which is easily available in a large diameter at a low cost, is adopted as a base substrate thereof. In this epitaxial substrate, the amount of warping is suppressed to 100 μm or less.

Moreover, when the second composition layer is made of AlGaN having an Al mole fraction of 0.1 or more and 0.25 or less, an epitaxial substrate that is crack-free and has a high breakdown voltage is achieved.

<Modification>

In the epitaxial substrate 10, an interface layer (not shown) may be provided between the base substrate 1 and the first base layer 2a. In one preferable example, the interface layer has a thickness of about several nm and is made of amorphous $SiAl_uO_vN_w$.

In a case where an interface layer is provided between the base substrate 1 and the first base layer 2a, a lattice misfit between the base substrate 1 and the second base layer 2b, and the like, is more effectively relieved, and the crystal quality of each layer formed thereon is further improved. That is, in a case where an interface layer is provided, an AlN layer that is the first base layer 2a is formed such that the AlN layer has a concavo-convex shape similar to a case where no interface layer is provided and such that the amount of crystal grain boundaries existing therein is reduced as compared with the case where no interface layer is provided. Particularly, the first base layer 2a having improvement in the half width value of the (0002) X-ray rocking curve is obtained. This is because, in a case where the first base layer 2a is formed on the interface layer, nucleus formation of AlN, which will make the first base layer 2a, is less likely to progress than in a case where the first base layer 2a is formed directly on the base substrate 1, and consequently the growth in the horizontal direction is promoted as compared with when no interface layer is provided. The film thickness of the interface layer is to an extent not exceeding 5 nm. In a case where such an interface layer is provided, the first base layer 2a can be formed such that the half width of the (0002) X-ray rocking curve is in a range of 0.5 degrees or more and 0.8 degrees or less. In this case, the function layer 6 can be formed with a more excellent crystal quality in which the half width of the (0002) X-ray rocking curve is 800 sec or less and the screw dislocation density is $1\times 10^9/cm^2$ or less.

The formation of the interface layer is achieved by, after the silicon wafer reaches the first base layer formation temperature and before the first base layer 2a is formed, introducing only an TMA bubbling gas into the reactor to expose the wafer to an TMA bubbling gas atmosphere.

Furthermore, in the formation of the first base layer 2a, at least one of Si atoms and O atoms may diffuse and form a solid solution in the first base layer 2a, or at least one of N atoms and O atoms may diffuse and form a solid solution in the base substrate 1.

Layer configurations of the composition modulation layers 3 included in the buffer layer 5 should not necessarily be the same, but may be different from one another.

EXAMPLES

(Examples)

A plurality of types of epitaxial substrates 10 were prepared, which were different from one another in terms of the layer configuration of the buffer layer 5 and the composition of the second composition layer 32. Table 1 shows the layer configuration of the buffer layer 5, the thickness of the intermediate layer 4, the total film thickness of the epitaxial film, and the total thickness of the second composition layer 32, in examples and comparative examples which will be described later.

[Table 1]

| Layer Configuration | | Thickness of i-th Second Composition Layer ($Al_xGa_{1-x}N$) [nm] | | | | | | | | | | The Number of Repetitions of Composition Modulation Layer | Thickness of Intermediate Layer [nm] | Total Film Thickness [μm] | Total Thickness of Second Composition Layers [nm] |
|---|---|---|---|---|---|---|---|---|---|---|---|---|---|---|---|
| | | i=1 | 2 | 3 | 4 | 5 | 6 | 7 | 8 | 9 | 10 | | | | |
| a | 1 | 10 | 20 | 40 | 80 | 160 | 320 | - | - | - | - | 3 | 10 | 3.0 | 1890 |
| | 2 | | | | | | | - | - | - | - | | 15 | 3.0 | |
| | 3 | | | | | | | - | - | - | - | | 30 | 3.0 | |
| | 4 | | | | | | | - | - | - | - | | 60 | 3.0 | |
| | 5 | | | | | | | - | - | - | - | | 90 | 3.1 | |
| | 6 | | | | | | | - | - | - | - | | 200 | 3.4 | |
| b | 1 | 10 | 20 | 40 | 80 | 160 | - | - | - | - | - | 6 | 10 | 3.0 | 1860 |
| | 2 | | | | | | - | - | - | - | - | | 15 | 3.0 | |
| | 3 | | | | | | - | - | - | - | - | | 30 | 3.0 | |
| | 4 | | | | | | - | - | - | - | - | | 60 | 3.3 | |
| | 5 | | | | | | - | - | - | - | - | | 90 | | |
| | 6 | | | | | | - | - | - | - | - | | 200 | 4.0 | |
| c | 1 | 15 | 30 | 60 | 120 | 240 | - | - | - | - | - | 4 | 10 | 3.0 | 1860 |
| | 2 | | | | | | - | - | - | - | - | | 15 | 3.0 | |
| | 3 | | | | | | - | - | - | - | - | | 30 | 3.0 | |
| | 4 | | | | | | - | - | - | - | - | | 60 | 3.1 | |
| | 5 | | | | | | - | - | - | - | - | | 90 | 3.2 | |
| | 6 | | | | | | | | | | | | 200 | 3.5 | |

(continued)

| Layer Configuration | | Thickness of i-th Second Composition Layer ($Al_xGa_{1-x}N$) [nm] | | | | | | | | | | The Number of Repetitions of Composition Modulation Layer | Thickness of Intermediate Layer [nm] | Total Film Thickness [$\mu$m] | Total Thickness of Second Composition Layers [nm] |
|---|---|---|---|---|---|---|---|---|---|---|---|---|---|---|---|
| | | i=1 | 2 | 3 | 4 | 5 | 6 | 7 | 8 | 9 | 10 | | | | |
| d | 1 | 15 | 15 | 15 | 15 | 15 | 80 | 80 | 80 | 160 | 160 | 3 | 10 | 3.1 | |
| | 2 | | | | | | | | | | | | 15 | 3.1 | |
| | 3 | | | | | | | | | | | | 30 | 3.1 | 1905 |
| | 4 | | | | | | | | | | | | 60 | 3.2 | |
| | 5 | | | | | | | | | | | | 90 | 3.2 | |
| | 6 | | | | | | | | | | | | 200 | 3.4 | |
| e | 1 | 15 | 15 | 15 | 15 | 15 | 15 | 15 | 50 | 100 | 200 | 4 | 10 | 3.0 | 1820 |
| | 2 | | | | | | | | | | | | 15 | 3.0 | |
| | 3 | | | | | | | | | | | | 30 | 3.1 | |
| | 4 | | | | | | | | | | | | 60 | 3.2 | |
| | 5 | | | | | | | | | | | | 90 | 3.3 | |
| | 6 | | | | | | | | | | | | 200 | 3.6 | |
| f | | (Alternately laminating 100 AlN layers of 5nm-thickness and 100 $Al_{0.1}Ga_{0.9}N$ layers of 15nm-thickness) | | | | | | | | | | | 3.0 | 1500 |
| g | | 240 | 240 | 240 | - | - | - | - | - | - | - | 3 | 15 | 3.2 | 2160 |
| h | | 160 | 160 | 160 | - | - | - | - | - | - | - | 4 | 15 | 3.0 | 1920 |

As for the layer configuration of the buffer layer 5 which more specifically means the number of the second composition layers 32, the thickness of each layer, and the number of repetitions of the composition modulation layer 3, five different types of layer configurations a to e were prepared. With respect to each of the layer configurations, two types of compositions, namely, $Al_{0.1}Ga_{0.9}N$ and $Al_{0.2}Ga_{0.8}N$ were adopted as the composition of the second composition layer 32. For the former, the intermediate layers 4 having six different thicknesses were prepared. For the latter, the intermediate layers 4 having four different thicknesses were prepared. The composition and the thickness of the base layer 2, the composition and the thickness of the first composition layer 31, and the composition and the thickness of the function layer 6 were identical for all specimens.

Until the formation of the second base layer 2b, the same procedure was performed for any of the specimens. A (111) plane single crystal silicon wafer (hereinafter, a silicon wafer) of four inches having the p-type conductivity and having a substrate thickness of 525 $\mu$m was prepared as the base substrate 1. The prepared silicon wafer was subjected to dilute hydrofluoric acid cleaning using dilute hydrofluoric acid having a composition of hydrofluoric-acid/pure-water = 1/10 (volume ratio), and subjected to SPM cleaning using cleaning liquid having a composition of sulfuric-acid/aqueous-hydrogen-peroxide = 1/1 (volume ratio). Thus, a state was created in which an oxide film having a thickness of several Å was formed on the wafer surface, which was then set in a reactor of a MOCVD apparatus. Then, a hydrogen/nitrogen mixed atmosphere was created in the reactor, and the pressure in the reactor was set to be 15 kPa. Heating was performed until the substrate temperature reached 1100°C that is the first base layer formation temperature.

When the substrate temperature reached 1100°C, a $NH_3$ gas was introduced into the reactor, and the substrate surface was exposed to a $NH_3$ gas atmosphere for one minute.

Then, a TMA bubbling gas was introduced into the reactor with a predetermined flow ratio, to react $NH_3$ with TMA, so that the first base layer 2a whose surface has a three-dimensional concavo-convex shape was formed. At this time, the growing speed (film formation speed) of the first base layer 2a was set to be 20 nm/min, and the target average film thickness of the first base layer 2a was set to be 100 nm.

After the first base layer 2a was formed, then the substrate temperature was set to be 1100°C and the pressure in the reactor was set to be 15 kPa. A TMG bubbling gas was further introduced into the reactor, to react $NH_3$ with TMA and TMG, so that an $Al_{0.1}Ga_{0.9}N$ layer serving as the first base layer 2b was formed so as to have an average film thickness of about 40 nm.

Subsequent to the formation of the second base layer 2b, the buffer layers 5 having five types of different layer configurations were formed as follows.

Layer Configuration a: In one composition modulation layer 3, the thickness of the second composition layer 32 was doubled stepwise from 10 nm to 320 nm, and six layers in total were formed. The number of repetitions of the composition modulation layer 3 was three.

Layer Configuration b: In one composition modulation layer 3, the thickness of the second composition layer 32 was doubled stepwise from 10 nm to 160 nm, and five layers in total were formed. The number of repetitions of the composition modulation layer 3 was six.

Layer Configuration c: In one composition modulation layer 3, the thickness of the second composition layer 32 was doubled stepwise from 15 nm to 240 nm, and five layers in total were formed. The number of repetitions of the composition modulation layer 3 was four.

Layer Configuration d: In one composition modulation layer 3, ten second composition layers 32 in total were prepared, in which each of first to fifth layers had a thickness of 15 nm, each of sixth to eighth layers had a thickness of 80 nm, and each of ninth and tenth layers had a thickness of 160 nm. The number of repetitions of the composition modulation layer 3 was three.

Layer Configuration e: In one composition modulation layer 3, ten second composition layers 32 in total were prepared, in which each of first to seventh layers had a thickness of 10 nm, and eighth to tenth layers had such thicknesses that the thickness was doubled stepwise from 50 nm to 200 nm. The number of repetitions of the composition modulation layer 3 was four.

In any of the specimens, all the first composition layers 31 and all the intermediate layers 4 were made of AlN. The thickness of the first composition layer 31 was 5 nm. With respect to the specimen including the second composition layers 32 having a composition of $Al_{0.1}Ga_{0.9}N$, six different thicknesses, namely, 10 nm, 15 nm, 30 nm, 60 nm, 90 nm, and 200 nm, were adopted as the thickness of the intermediate layer 4. With respect to the specimen including the second composition layers 32 having a composition of $Al_{0.2}Ga_{0.8}N$, four different thicknesses other than 10 nm and 200 nm among those thicknesses, were adopted as the thickness of the intermediate layer 4.

In the formation of the buffer layer 5, the substrate temperature was set to be 1100°C, and the pressure in the reactor was set to be 15 kPa. The same material gas as for the formation of the base layer 2 was used.

In any of the specimens, after the buffer layer 5 was formed, the function layer 6 made of GaN was formed with a thickness of 700 nm. In the formation of the function layer 6, the substrate temperature was set to be 1100°C, and the pressure in the reactor was set to be 15 kPa. In any of the formations, the same material gas as for the formation of the base layer 2 was used.

Through the above-described process, 50 types of epitaxial substrates were obtained in total.

(Comparative Examples 1 to 3)

As comparative examples, three types of layer configurations (layer configurations *f* to *h*) different from one another in terms of the configuration of the buffer layer 5 were prepared.
In a comparative example 1 (layer configuration *f*), an epitaxial substrate including a so-called superlattice layer was prepared, in which, instead of the composition modulation layers 3 and the intermediate layers 4 being alternately provided, 100 AlN layers each having a thickness of 5 nm and 100 $Al_{0.1}Ga_{0.9}N$ layers each having a thickness of 15 nm were alternately laminated. Conditions under which the AlN layers and the $Al_{0.1}Ga_{0.9}N$ layers were formed were the same as the conditions under which the first composition layers 31 and the second composition layers 32 of the examples were formed, respectively.
In a comparative example 2 (layer configuration *g*) and a comparative example 3 (layer configuration *h*), epitaxial substrates were prepared, each having such composition modulation layers 3 that all the second composition layers 32 had the same thickness. In the comparative example 2, the thickness of the second composition layer 32 was 240 nm, the thickness of the intermediate layer 4 was 15 nm, and the number of repetitions of the composition modulation layer 3 was three. In the comparative example 3, the thickness of the second composition layer 32 was 160 nm, the thickness of the intermediate layer 4 was 15 nm, and the number of repetitions of the composition modulation layer 3 was four.

(Evaluation Results of Example and Comparative Examples)

For the epitaxial substrates obtained in the examples and the comparative examples, the presence or absence of occurrence of cracking was visually checked. Additionally, the amount of warping was measured using a laser displacement gauge. Furthermore, for the epitaxial substrates where no cracking occurred, the breakdown voltage was measured. Evaluation results of the epitaxial substrates according to the examples and the comparative examples are shown in Table 2.
[Table 2]

| Layer Configuration No. | Second Composition Layer $Al_{0.1}Ga_{0.9}N$ | | | Second Composition Layer $Al_{0.2}Ga_{0.8}N$ | | |
| --- | --- | --- | --- | --- | --- | --- |
| | Occurrence of Cracking | Warping [$\mu$m] | Breakdown Voltage [V] | Occurrence of Cracking | Warping [$\mu$m] | Breakdown Voltage [V] |
| a-1 | Occurred at 20 nm from Outer Periphery | 128 | - | - | - | - |
| a-2 | Not Observed | | 630 | Not Observed | 85 | 765 |
| a-3 | Not observed | 73 | 635 | Not Observed | 79 | 770 |
| a-4 | Not Observed | | 620 | Not Observed | | |
| a-5 | Not Observed Occurred at 20 mn from | 62 | 630 | Not Observed | 68 | 750 |
| a-6 | Outer Periphery | 140 | - | - | - | - |
| b-1 | Occurred at 20 nm from Outer Periphery | 135 | - | - | | - |
| b-2 | Not Observed | 78 | 625 | Not Observed | 84 | 765 |
| b-3 | Not Observed | 72 | 630 | Not Observed | 80 | 755 |
| b-4 | | 70 | 635 | Not Observed | 76 | 765 |
| b-5 | Not Observed | 63 | 625 | Not Observed | 70 | 755 |

(continued)

| Layer Configuration No. | Second Composition Layer Al$_{0.1}$Ga$_{0.9}$N | | | Second Composition Layer Al$_{0.2}$Ga$_{0.8}$N | | |
|---|---|---|---|---|---|---|
| | Occurrence of Cracking | Warping [μm] | Breakdown Voltage [V] | Occurrence of Cracking | Warping [μm] | Breakdown Voltage [V] |
| b-6 | Occurred at 20 nm from Outer Periphery | 165 | - | - | | - |
| c-1 | Occurred at 20 nm from Outer Periphery | 125 | - | - | | - |
| c-2 | Not Observed | 79 | 630 | Not Observed | 86 | |
| c-3 | Not Observed | 72 | 625 | Not Observed | 79 | 755 |
| c-4 | | 68 | 635 | Not Observed | 72 | |
| c-5 | Not Observed | 62 | 620 | Not Observed | 66 | 760 |
| c-6 | c-6 Occurred at 20 nm from Outer Periphery | 139 | - | - | | - |
| d-1 | Occurred at 20 nm from Outer Periphery | 138 | - | - | | - |
| d-2 | Not Observed | 80 | 630 | Not Observed | 83 | 765 |
| d-3 | Not Observed | 74 | 635 | Not Observed | 78 | 770 |
| d-4 | Not Observed | 68 | 625 | Not Observed | 73 | 760 |
| d-5 | Not Observed Occurred at 20 mn from | 61 | 620 | Not Observed | 67 | 765 |
| d-6 | Outer Periphery | 145 | - | - | | - |
| e-1 | Occurred at 20 nm from Outer Periphery | 125 | - | - | | - |
| e-2 | Not Observed | 81 | 635 | Not Observed | 86 | |
| | Not Observed | 74 | 640 | Not Observed | 79 | 760 |
| e-3 e-4 | Not Observed | 67 | 625 | Not Observed | 73 | |
| e-5 | Not Observed | 60 | 635 | Not Observed | 68 | 765 |
| e-6 | Occurred at 20 nm from 156 Outer Periphery | 156 | - | - | | - |
| f | Occurred at 20 nm from Outer Periphery | 138 | - | - | - | - |
| g | Occurred at 20 nm from Outer Periphery | 125 | - | - | - | - |

(continued)

| Layer Configuration No. | Second Composition Layer $Al_{0.1}Ga_{0.9}N$ | | | Second Composition Layer $Al_{0.2}Ga_{0.8}N$ | | |
|---|---|---|---|---|---|---|
| | Occurrence of Cracking | Warping [$\mu$m] | Breakdown Voltage [V] | Occurrence of Cracking | Warping [$\mu$m] | Breakdown Voltage [V] |
| h | Occurred at 20 nm from Outer Periphery | 115 | - | - | - | - |

As shown in Table 2, in all the specimens of the comparative examples 1 to 3 and in the specimens of the examples in which the thickness of the intermediate layer was 10 nm or 200 nm, cracking occurred at 20 mm from the outer periphery. On the other hand, in the specimens of the examples in which the thickness of the intermediate layer was in a range of 15 nm or more and 150 nm or less, no cracking was observed.

In the specimens where cracking occurred, the amount of warping exceeded 100 $\mu$m, while in the specimens where no cracking occurred, the amount of warping was suppressed to 100 $\mu$m or less.

The above-mentioned results indicate that alternately and repeatedly laminating the composition modulation layers 3 in which the thickness of the second composition layer increases in a portion more distant from the base substrate and the intermediate layers 4 having a thickness of 15 nm or more and 150 nm or less, is effective in achieving a crack-free state of the epitaxial substrate 10 and suppression of warping therein.

In the comparative example 1, the $Al_{0.1}Ga_{0.9}N$ layer which corresponds to the second composition layer 32 has a relatively small thickness of 15 nm, and therefore it would be guessed that the $Al_{0.1}Ga_{0.9}N$ layer itself grew in a coherent state. Despite this, cracking occurred in the comparative example 1. Accordingly, it is considered that, in a case of simply providing a superlattice layer alone as in the comparative example 1, the compressive strain is introduced into each individual second composition layer 32 but the total sum thereof is not sufficient for canceling the tensile stress.

It is contemplated that the reason why cracking occurred in the comparative examples 2 and 3 is because there was a large difference between the thickness of the first composition layer 31 that was the first layer and the thickness of the second composition layer 32<1> that was formed thereon, so that the second composition layer 32<1> could not maintain its coherent state.

Comparing the amounts of warping in the specimens where no cracking occurred, there was a tendency that the amount of warping decreases as the thickness of the intermediate layer 4 is greater.

In all the specimens where no cracking occurred, the total thickness of the second composition layers was 1700 nm0 or more and the breakdown voltage was 600V or higher. Moreover, in all the specimens having the second composition layers 32 made of $Al_{0.2}Ga_{0.8}N$, the breakdown voltage was 700V or higher and the breakdown voltage was higher by 100V or more than the breakdown voltage of the specimen having the second composition layers 32 made of $Al_{0.1}Ga_{0.9}N$, though the amounts of warping in both of them were almost similar.

**Claims**

1. An epitaxial substrate in which a group of group-III nitride layers are formed on a base substrate made of (111)-oriented single crystal silicon such that a (0001) crystal plane of said group of group-III nitride layers is substantially in parallel with a substrate surface of said base substrate, said epitaxial substrate comprising:

   a buffer layer formed of a first lamination unit and a second lamination unit being alternately laminated such that each of an uppermost portion and a lowermost portion of said buffer layer is formed of said first lamination unit; and
   a crystal layer formed on said buffer layer,
   wherein
   said first lamination unit is formed of a first composition layer and a second composition layer having different compositions being alternately laminated so as to satisfy the expressions of:

$$t(1) \leq t(2) \leq \ldots \leq t(n-1) \leq t(n);$$

   and

$$t(1) < t(n),$$

where n represents the number of laminations of each of said first composition layer and said second composition layer (n is a natural number equal to or greater than two), and t(i) represents the thickness of i-th one of said second composition layers as counted from said base substrate side, to thereby cause a compressive strain to exist in said first lamination unit such that said compressive strain increases in a portion more distant from said base substrate,

said second lamination unit is an intermediate layer that is substantially strain-free and formed with a thickness of 15 nm or more and 150 nm or less.

2. The epitaxial substrate according to claim 1, wherein
a second group-III nitride of said second composition layer has an in-plane lattice constant, under a strain-free state, greater than that of a first group-III nitride of said first composition layer,
each of said second composition layers is formed so as to be in a coherent state relative to said first composition layer.

3. The epitaxial substrate according to claim 2, wherein
said intermediate layer is made of a third group-III nitride whose in-plane lattice constant under a strain-free state is smaller than that of said second group-III nitride.

4. An epitaxial substrate in which a group of group-III nitride layers are formed on a base substrate made of (111)-oriented single crystal silicon such that a (0001) crystal plane of said group of group-III nitride layers is substantially in parallel with a substrate surface of said base substrate, said epitaxial substrate comprising:

a buffer layer formed of a first lamination unit and a second lamination unit being alternately laminated such that each of an uppermost portion and a lowermost portion of said buffer layer is formed of said first lamination unit; and
a crystal layer made of a group-III nitride and formed on said buffer layer,
wherein
said first lamination unit is formed of a first composition layer made of a first group-III nitride and a second composition layer made of a second group-III nitride being alternately laminated so as to satisfy the expressions of:

$$t(1) \leq t(2) \leq \ldots \leq t(n-1) \leq t(n);$$

and

$$t(1) < t(n),$$

where n represents the number of laminations of each of said first composition layer and said second composition layer (n is a natural number equal to or greater than two), and t(i) represents the thickness of i-th one of said second composition layers as counted from said base substrate side,
said second group-III nitride has an in-plane lattice constant, under a strain-free state, greater than that of said first group-III nitride,
each of said second composition layers is formed so as to be in a coherent state relative to said first composition layer,
said second lamination unit is an intermediate layer made of a third group-III nitride formed with a thickness of 15 nm or more and 150 nm or less, said third group-III nitride having an in-plane lattice constant, under a strain-free state, smaller than that of said second group-III nitride.

5. The epitaxial substrate according to any one of claims 1 to 4, wherein
said first composition layer is made of AlN, and said second composition layer is made of a group-III nitride having a composition of $Al_xGa_{1-x}N$ ($0 \leq x \leq 0.25$).

6. The epitaxial substrate according to claim 5, wherein

said second composition layer is made of a group-III nitride having a composition of $Al_xGa_{1-x}N$ (0.1≤x≤0.25).

7. The epitaxial substrate according to any one of claims 1 to 6, further comprising:

a first base layer made of AlN and formed on said base substrate; and
a second base layer made of $Al_pGa_{1-p}N$ (0≤p<1) and formed on said first base layer,
wherein
said first base layer is a layer with many crystal defects configured of at least one kind from a columnar or granular crystal or domain,
an interface between said first base layer and said second base layer defines a three-dimensional concavo-convex surface,
said buffer layer is formed immediately on said second base layer.

8. A method for manufacturing an epitaxial substrate for use in a semiconductor device, said epitaxial substrate having a group of group-III nitride layers formed on a base substrate made of (111)-oriented single crystal silicon such that a (0001) crystal plane of said group of group-III nitride layers is substantially in parallel with a substrate surface of said base substrate, said method comprising:

a buffer layer formation step for forming a buffer layer by alternately laminating a first lamination unit and a second lamination unit such that each of an uppermost portion and a lowermost portion of said buffer layer is formed of said first lamination unit; and
a crystal layer formation step for forming a crystal layer above said buffer layer, said crystal layer being made of a group-III nitride,
wherein
said buffer layer formation step includes:

a first lamination unit formation step for forming said first lamination unit by alternately laminating a first composition layer made of a first group-III nitride and a second composition layer made of a second group-III nitride; and
said second lamination unit formation step for forming an intermediate layer on said first lamination unit,

in said first lamination unit formation step, said first lamination unit is formed in such a manner that:

the expressions of:

$$t(1) \leq t(2) \leq \ldots \leq t(n-1) \leq t(n);$$

and

$$t(1) < t(n),$$

are satisfied, where n represents the number of laminations of each of said first composition layer and said second composition layer (n is a natural number equal to or greater than two), and t(i) represents the thickness of i-th one of said second composition layers as counted from said base substrate side;
said second group-III nitride has an in-plane lattice constant, under a strain-free state, greater than that of said first group-III nitride; and
each of said second composition layers is in a coherent state relative to said first composition layer,

in said second lamination unit formation step, said intermediate layer is formed with a thickness of 15 nm or more and 150 nm or less by using a third group-III nitride, said third group-III nitride having an in-plane lattice constant, under a strain-free state, smaller than that of said second group-III nitride.

9. The method for manufacturing the epitaxial substrate according to claim 8, wherein
said first composition layer is made of AlN, and said second composition layer is made of a group-III nitride having a composition of $Al_xGa_{1-x}N$ (0≤x≤0.25).

10. The method for manufacturing the epitaxial substrate according to claim 8 or 9, wherein
said second composition layer is made of a group-III nitride having a composition of $Al_xGa_{1-x}N$ ($0.1 \leq x \leq 0.25$).

11. The method for manufacturing the epitaxial substrate according to any one of claims 8 to 10, further comprising:

a first base layer formation step for forming a first base layer on said base substrate, said first base layer being made of AlN; and
a second base layer formation step for forming a second base layer on said first base layer, said second base layer being made of $Al_pGa_{1-p}N$ ($0 \leq p \leq 1$),
wherein
in said first base layer formation step, said first base layer is formed as a layer with many crystal defects configured of at least one kind from a columnar or granular crystal or domain, such that a surface thereof is a three-dimensional concavo-convex surface,
in said buffer layer formation step, said buffer layer is formed immediately on said second base layer.

FIG. 1

F I G .  2

(a)

(b)

(c)

ORIGINAL LATTICE LENGTH
$a_0$

STRAIN
$s$

ACTUAL LATTICE
LENGTH $a$

$a_0$

$s$

$a$

$a=a_0$

MISFIT
DISLOCATION

32

31

EP 2 554 719 A1

24

## INTERNATIONAL SEARCH REPORT

| | International application No. |
|---|---|
| | PCT/JP2011/055990 |

A. CLASSIFICATION OF SUBJECT MATTER
*C30B29/38*(2006.01)i, *C30B29/06*(2006.01)i, *H01L21/205*(2006.01)i,
*H01L21/338*(2006.01)i, *H01L29/778*(2006.01)i, *H01L29/812*(2006.01)i

According to International Patent Classification (IPC) or to both national classification and IPC

B. FIELDS SEARCHED

Minimum documentation searched (classification system followed by classification symbols)
C30B29/38, C30B29/06, H01L21/205, H01L21/338, H01L29/778, H01L29/812

Documentation searched other than minimum documentation to the extent that such documents are included in the fields searched
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)
Science Direct, JSTPlus(JDreamII),
Science Citation Index Expanded(Web of Science)

C. DOCUMENTS CONSIDERED TO BE RELEVANT

| Category* | Citation of document, with indication, where appropriate, of the relevant passages | Relevant to claim No. |
|---|---|---|
| Y | Takaaki SUZUE et al., "Study on AlGaN/GaN HEMTs on Si (111) substrates with thick AlGaN/GaN, GaN/AlN and AlGaN/GaN multilayers", IEICE Technical Report, vol.108, no.322, 20 November 2008 (20.11.2008), pages 137 to 140 | 1,2,5-7 |
| Y | JP 2009-289956 A (The Furukawa Electric Co., Ltd.), 10 December 2009 (10.12.2009), claims; paragraphs [0020] to [0037]; fig. 1 (Family: none) | 1,2,5-7 |
| Y | ERIC FELTIN, et al., Stress control in GaN grown on silicon (111) by metalorganic vaporphase epitaxy, APPLIED PHYSICS LETTERS, VOLUME 79, NUMBER 20, 2001.11.12, pp.3230-3232 | 1,2,5-7 |

☒ Further documents are listed in the continuation of Box C.　　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 20 April, 2011 (20.04.11) | 17 May, 2011 (17.05.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**EP 2 554 719 A1**

| INTERNATIONAL SEARCH REPORT | International application No. |
|---|---|
| | PCT/JP2011/055990 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-527988 A (Emcore Corp.), 15 September 2005 (15.09.2005), paragraphs [0021] to [0025]; fig. 1 & EP 1568083 A    & WO 2004/051707 A2 & DE 10392313 T    & TW 249246 B & KR 10-2005-0084774 A   & CN 1692499 A | 1-11 |
| A | S. LAWRENCE SELVARAJ, et al., AlN/AlGaN/GaN metal-insulator-semiconductor high-electron-mobilitytransistor on 4 in. silicon substrate for high breakdown characteristics, APPLIED PHYSICS LETTERS, Vol.90, 2007, Article No.173506 | 1-11 |
| A | JP 2005-158846 A (Sanken Electric Co., Ltd.), 16 June 2005 (16.06.2005), claims; fig. 1 (Family: none) | 1-11 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10163528 A
- JP 2004349387 A
- JP 2005350321 A
- JP 2009289956 A

**Non-patent literature cited in the description**

- **TOSHIHIDE KIKKAWA.** Highly Reliable 250W GaN High Electron Mobility Transistor Power Amplifier. *Jpn. J. Appl. Phys.,* 2005, vol. 44, 4896

- **NARIAKI IKEDA ; SYUUSUKE KAYA ; JIANG LI ; YOSHIHIRO SATO ; SADAHIRO KATO ; SEIKOH YOSHIDA.** High power AlGaN/GaN HFET with a high breakdown voltage of over 1.8kV on 4 inch Si substrates and the suppression of current collapse. *Proceedings of the 20th International Symposium on Power Semiconductor Devices & IC's,* 18 May 2008, 287-290